# EUROPÄISCHE PATENTSCHRIFT

(11) **EP 3 381 246 B1**
(45) Veröffentlichungstag und Bekanntmachung des Hinweises auf die Patenterteilung: **19.08.2020**
(21) Anmeldenummer: 16784180.8
(22) Anmeldetag: 19.10.2016
(51) Int. Cl.: H05K 5/00, H05K 3/28, H05K 3/36, H05K 1/14, H05K 5/06

(54) **ELEKTRONIKMODUL UND VERFAHREN ZUM HERSTELLEN EINES ELEKTRONIKMODULS MIT EINEM FLUIDDICHTEN GEHÄUSE**
ELECTRONIC MODULE AND METHOD FOR PRODUCING AN ELECTRONIC MODULE HAVING A FLUID-TIGHT HOUSING
MODULE ÉLECTRONIQUE ET PROCÉDÉ DE FABRICATION D'UN MODULE ÉLECTRONIQUE AVEC UN BOÎTIER ÉTANCHE AUX FLUIDES

(30) Priorität: 27.11.2015 DE 102015223550
(43) Veröffentlichungstag der Anmeldung: 03.10.2018
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2016/075035
(87) Internationale Veröffentlichungsnummer: WO 2017/089031

(56) Entgegenhaltungen:
- DE-A1- 3 942 392
- DE-A1-102011 088 969
- DE-A1-102011 088 970
- DE-A1-102013 215 227
- DE-A1-102013 215 246
- DE-A1-102014 205 385

## Beschreibung

### Gebiet der Erfindung

Die Erfindung betrifft allgemein Elektronikmodule und ein Verfahren zum Herstellen eines Elektronikmoduls mit einem fluiddichten Gehäuse.

### Stand der Technik

Im Automatikgetriebe eines Kraftfahrzeugs gibt es zur Steuerung der Kupplungs- und Schaltvorgänge Getriebesteuermodule, die im ölgefüllten Getriebeinnenraum eingebaut sind. Die Getriebesteuermodule haben in der Regel für die Elektronik ein eigenes fluiddichtes Gehäuse für die Getriebesteuereinheit (TCU, Transmission Control Unit), die Leistungselektronik und zum Beispiel eine Schaltung auf Stanzgittern (DBC, Direct Bonded Copper). Die Elektronik ist in Form eines duroplastischen Mold-Gehäuses oder eines Stahlgehäuses oder mittels eines Kunststoffdeckels mit Dichtungen zum übrigen Getriebesteuermodulgehäuse geschützt. Bei flexiblen oder starren Leiterplatten, FPCs oder PCBs, als Modul-Aufbau- und Verbindungstechnik (AVT) haben diese AVT's einen Ausschnitt für die Getriebesteuereinheit, damit die Getriebesteuereinheit wärmeleitend in diesem Ausschnitt auf einer Trägerplatte aufgeklebt oder mit einer Feder auf dieser niedergehalten werden kann.

Getriebesteuereinheiten mit Stahlgehäuse haben in der Regel sehr aufwändige Pin-Durchführungen in Form von eingeglasten Ni-Fe-Pins und teuren Gehäuseteilen. Außerdem ist der Aufbau von der Geometrie aus gesehen sehr hoch, das heißt sperrig, da die Pins senkrecht statt waagerecht aus dem Gehäuse kommen. Die Dichtheit ist dafür sehr gut. Gegebenenfalls wird die gesamte Getriebesteuereinheit einem sogenannten Burn-in oder einem Hoch-Tief-Temperatur-Test unterzogen. Die Positionierung und Niederhaltung der TCU, Getriebesteuereinheit, im Getriebe erfolgt mittels einer Feder, damit die Getriebesteuereinheit gut wärmeleitend an ein kühlendes Getriebebauteil, zum Beispiel eine Hydraulikplatte, gepresst wird.

Bei Getriebesteuereinheiten, die mit einer Vergussmasse umspritzt sind, sogenannte Mold-TCU's, muss der Schaltungsträger (HDI-PCB, LTCC) auf eine Metall- oder Keramikplatte geklebt werden und es müssen komplexe Stanzgitterteile um den Schaltungsträger der Getriebesteuereinheit herum platziert werden. Ferner müssen Bondverbindungen, das heißt elektrisch leitende Verbindungen zwischen dem Schaltungsträger und diesem Stanzgitter, erzeugt werden. Danach erfolgt ein Einlegen der Getriebesteuereinheit in ein sogenanntes Mold-Werkzeug zum Umspritzen. Nach dem Umspritzen (Molding) muss das Stanzgitter im Austritt aus der Moldmasse, d.h. Vergussmasse, freigestanzt werden, damit Einzelpins entstehen. Die Pins müssen nachträglich aufwändig gereinigt und verzinnt werden.

Die Getriebesteuereinheiten (TCU's) mit einem Kunststoffdeckel werden durch einen Dichtring oder eine Klebenaht gegen eine Modulflexfolie (FPC) abgedichtet, um eventuell doch eindringendes Öl möglichst am Rand des Deckels abzufangen. Wegen potenzieller Dichtheitsprobleme zwischen Deckel und FPC, oder FPC oder Trägerplatte und um einem möglichen thermischen Pumpeffekt eines Luftraums unter dem Deckel zu vermeiden, wird der Innenraum des Deckels und des Gehäuses aufwändig mit einem Gel befüllt.

Bei mit einer Vergussmasse vergossenen integrierten Getriebesteuereinheiten wird eine Bare-Die-Schaltung auf einer HDI-PCB, also starren Leiterplatte oder einer LTCC-Keramik mit einem Verguss aus Epoxidharz, Polyester, Polyurethan, etc. komplett vergossen.

Die DE 10 2013 215 246 A1 beschreibt ein Elektronikmodul mit Leiterplatten und einem anspritzbaren Kunststoff-Dichtring, insbesondere für ein Kfz-Getriebesteuergerät, wobei am äußeren Umfang eines ersten Leiterplattenelements jeweils ringförmig umlaufend eine Mikrostrukturierung ausgebildet ist und auf der nach außen gerichteten Oberfläche des zweiten Leiterplattenelements eine korrespondierende ringförmige umlaufende Mikrostrukturierung ausgebildet ist, die mittels eines Dichtrings eine formschlüssige Verbindung sowohl mit der an dem ersten Leiterplattenelement ausgebildeten Mikrostrukturierung als auch eine formschlüssige Verbindung mit der an dem zweiten Leiterplattenelement ausgebildeten Mikrostrukturierung erzeugt.

DE 10 2018 215227 A1, DE 10 2011 088989 A1, DE 10 2011 088970 A1, DE 10 2014 205385 A1 und DE 89 42 892 A1 offenbaren weiteren Stand der Technik betreffend Elektronikmodule.

### Offenbarung der Erfindung

### Vorteile der Erfindung

Ausführungsformen der vorliegenden Erfindung können in vorteilhafter Weise ermöglichen, ein einfaches, zuverlässiges, robustes, fluiddichtes Elektronikmodul sowie ein Verfahren zum Herstellen eines fluiddichten Elektronikmoduls mit reduzierten Fixkosten bereitzustellen.

Gemäß einem ersten Aspekt der Erfindung wird ein Elektronikmodul, insbesondere für ein Getriebesteuermodul eines Kraftfahrzeugs, geschaffen, das eine erste Leiterplatte mit elektronischen Bauelementen, Abstandshaltern, die zumindest in Eckbereichen der ersten Leiterplatte aufliegend angeordnet sind, eine Deckelplatte, wobei die Deckelplatte auf den Abstandshaltern angeordnet ist und eine Vergussmasse aufweist, die als stirnseitiger Verschluss eine durch die Abstandshalter erzeugte Beabstandung zwischen Leiterplatte und Deckelplatte zu einem Gehäuse für die darin angeordneten elektronischen Bauelemente abdichtet.

Das erfindungsgemäße Elektronikmodul zeichnet sich insbesondere dadurch aus, dass die Vergussmasse an der Leiterplatte stoffschlüssig die Deckelplatte sichert, wobei der thermische Längenausdehnungskoeffizient (CTE) von der Vergussmasse im Wesentlichen mit den thermischen Längenausdehnungskoeffizienten (CTE) von der Leiterplatte und der Deckelplatte übereinstimmt. Dies bringt mehrere Vorteile mit sich. Es müssen nicht, wie oben beschrieben, Mikrostrukturen in der ersten und zweiten Leiterplatte vorgesehen sein, um ein formschlüssiges Gehäuse mittels eines mechanischen "Verkrallen" zu erzeugen. Die Adhäsionskräfte der Vergussmasse reichen aus, um eine stoffschlüssige Verbindung zwischen Leiterplatte und Deckenplatte zu erzeugen und somit ein Gehäuse fluiddicht bereitzustellen. Die Stabilität und Dichtigkeit des Elektronikmoduls bleibt zudem bei thermischen Beeinträchtigungen beständig, Rissbildungen werden vermieden.

Erfindungsgemäß beträgt die Abweichung des thermischen Längenausdehnungskoeffizienten (CTE) zwischen dem CTE der Vergussmasse und dem CTE der Leiterplatte und/oder dem der Deckelplatte maximal 5-10 ppm/K. Somit dehnen sich die Vergussmasse und die Deckel- und die Leiterplatte im gleichen Maße bei einer thermischen oder mechanischen Beeinträchtigung aus. Risse werden somit vermieden. Eine hohe Abdichtung wird damit sichergestellt.

Gemäß einer weiter bevorzugten Ausführungsform weist die Vergussmasse einen Längenausdehnungskoeffizienten (CTE) von ca. 20 ppm/K auf. Es ist überraschenderweise herausgefunden worden, dass ein CTE von 20 ein gutes Maß zwischen einem hohen CTE mit wenigen bis sehr wenigen Füllstoffen und einem niedrigen CTE ist, der mit mineralischen Füllstoffen gesenkt wird. Duroplaste weisen in der Regel einen CTE von 60-70 auf. Je weiter der CTE unter einer gewissen Grenze, beispielsweise unter 20 ppm/K liegt, desto stärker sinkt die Festigkeit der Vergussmasse.

Um eine sehr gute Lebensdauerfestigkeit und Lebensdauerdichtigkeit zu erreichen, ist erfindungsgemäß die Leiterplatte mit einem CTE von ca. 18 ppm/K ausgebildet ist, wobei die Deckelplatte, insbesondere aus Stahl je nach Legierung von Ni-Stählen mit einem CTE zwischen 11 bis 20 ppm/K, weiter bevorzugt aus Aluminium mit einem CTE bei ca. 23 ppm/K, und besonders bevorzugt aus Epoxidharz, mit einem CTE um ca. 20 ppm/K hergestellt ist.

Statt eines Metalldeckels kann also eine Epoxidharzplatte als Deckelplatte verwendet werden, eine zum Beispiel aus Leiterplatten-Pre-Pregs oder Leiterplatten-Kernen hergestellte Platte, die keine Schaltungsverdrahtung enthält. Die Anzahl der verwendeten Pre-Pregs oder Kerne richtet sich nach der benötigten Steifigkeit des Deckels bzw. der Deckelplatte, die aber auch zusätzlich zum Beispiel mittig angeklebt werden könnte.

Um thermischen und mechanischen Beanspruchungen zu widerstehen und somit Risse zu vermeiden, ist die Vergussmasse ein Epoxidharz aus der Gruppe der Säureanhydrid-härtenden Epoxide. Diese Vergussmasse ist säurebeständig und gegenüber höheren Temperaturen sehr gut beständig sowie sehr leicht mit einem CTE unter 20 ppm/K verfügbar.

Gemäß einem weiteren Gedanken der Erfindung ist die Vergussmasse ein Epoxidharz aus der Gruppe der aminisch härtenden Epoxide Der große Vorteil der aminisch härtenden Epoxiden besteht darin, dass eine besser Gesundheits- und Umweltverträglichkeit bei der Herstellung vorliegt, da weniger Schadstoffe entstehen.

Aus all diesen Gründen ist überraschender Weise herausgefunden worden, dass eine stoffschlüssige Verbindung gegenüber der aus dem Stand der Technik bekannt formschlüssigen Verbindung zur Ausbildung eines stabilen, fluiddichten Gehäuses ausreicht. Die Lösung der Kapselung der Leiterplatte mit ihren elektronischen Bauelementen als Gehäuse bringt gegenüber einer Vergussmasse, das heißt Molden von Bare-Die-Elektronikmodulen große Vorteile. Es können hochminiaturisierte Bare-Die-Elektroniken eingesetzt werden, ohne diese speziell zu umspritzen. Aufgrund der fortschreitenden Miniaturisierung der Mikrocomputer und der Speicherchips sind die Anforderungen an einen direkten Schutz mit einer Mold- und Vergussmasse immer höher. Die Kontaktabstände für die Bonddrähte, Lötzinnpins und Lötkugeln, sogenannten Ball-Grids, werden immer kleiner. Aufgrund der geringer werdenden Abstände zwischen zwei Bonddrähten zum Beispiel von 20 bis 40 µm steigen die Anforderungen an die mineralischen Füllstoffe der Mold-Vergussmassen und somit der Kosten mehr als proportional. Eine Masse mit einer Füllstoffgröße von 20 statt 50 µm ist also zudem um ein Mehrfaches kostenintensiver. Außerdem steigt bei der Miniaturisierung, einer Verkleinerung der Siliziumstrukturen der Mikrocomputer und Speicher von 90 nm auf 40 nm oder 28 nm die Empfindlichkeit gegen in den Massen enthaltenen Ionen und gegen die von den Füllstoffen abgestrahlten Alphastrahlen. Bei Abständen von 20 µm passen größere Füllstoffe nicht durch und die Masse wird hier entmischt. An den empfindlichen Stellen der Verbindung zum Schaltungsträger liegt nun somit eine Vergussmasse mit kaum noch Füllstoffen vor. Die Materialeigenschaften wie der thermische Längenausdehnungskoeffizient (CTE), Festigkeit usw. verändern sich sehr stark. Aufgrund der Schaffung eines Gehäuses sind zudem keine Werkzeugkosten für eine Vergussmasse oder für ein Mold-Werkzeug keine Werkzeugkosten für ein Stanzen der Pins notwendig. Es wird die Bauhöhe reduziert und zusätzliche Bauteile und Material für ein Gehäuse fallen weg. Außerdem sinken die Fixkosten, so dass der Anteil der variablen Kosten, das heißt der bauteilabhängigen Kosten, ansteigt. Somit können schnell beliebig, in einer beliebigen Anzahl Freiformen des Elektronikmoduls geschaffen werden. Außerdem besteht das Problem der Alphastrahlen nicht, da hier kein Füllmaterial eingesetzt wird, sondern die Bare-Die-Elektroniken nur mit einem Lack oder Gel geschützt werden können, das kostengünstig ist und aufgrund des fluiddichten Gehäuses nicht fluidbeständig, insbesondere nicht ölbeständig, sein muss.

Gemäß einer die Erfindung weiterbildenden Ausführungsform, um das Elektronikmodul noch kompakter bereitzustellen, ist die Deckelplatte als zweite Leiterplatte mit elektronischen Bauelementen ausgebildet und die erste und zweite Leiterplatte sind mittels eines flexiblen Kabels miteinander verbunden, wobei insbesondere die zweite Leiterplatte beidseitig mit elektronischen Bauelementen bestückt ist und die äußere Seite der zweiten Leiterplatte mit elektronischen Bauelementen von der Vergussmasse umhüllend ausgebildet ist. Durch eine beidseitige bestückte Leiterplatte kann das Elektronikmodul noch kompakter ausgebildet werden. Es versteht sich, dass auch die erste Leiterplatte beidseitig mit elektronischen Bauelementen bestückt sein kann.

Um die Bauhöhe und das Gewicht zu reduzieren, ist bevorzugt die Vergussmasse und die Deckelplatte am Außenumfang übergreifend ausgebildet, insbesondere bedeckt die Vergussmasse die gesamte Deckelplatte oder weiter bevorzugt ist die Vergussmasse in einem äußeren Kanal zwischen Deckelplatte und Vergussmasse und Abstandshaltern ein Gehäuse bildend ausgebildet. Der Werkstoffbedarf an Vergussmasse ist insbesondere, wenn die Vergussmasse in einem äußeren Kanal einen Dichtring bildet, deutlich reduziert. Dies ist wichtig, da die Vergussmasse einen wesentlichen Kostenfaktor darstellt.

Um mit einer möglicherweise sehr kostenintensiven Vergussmasse kostengünstig ein abgeschlossenes Elektronikmodul zu schaffen, ist gemäß einer alternativen Ausführungsform ein Abstandhaltering vorgesehen, der die Abstandshalter umfasst und als geschlossener, insbesondere in einem Rechteckprofil geformter, Ring ausgebildet ist, wobei die Vergussmasse nur jeweils auf gegenüberliegenden Oberflächen des Abstandhalterings zwischen Leiterplatte und Deckelplatte angeordnet ist und diese den stirnseitigen, abdichtenden Verschluss ausbildet. Somit ist der Bedarf der Menge von der Vergussmasse nochmals deutlich niedriger als in den vorher beschriebenen Ausführungsbeispielen.

Erfindungsgemäß ist die Vergussmasse auf einer Trägerplatte angeordnet und die erste Leiterplatte ist direkt auf der Trägerplatte aufliegend angeordnet, wobei insbesondere ein Kabel an der äußeren Oberseite der Deckelplatte zu einem elektronischen Anbauteil einer dritten Leiterplatte auf der Trägerplatte liegend angeordnet ist. Somit können beispielsweise Steckverbinder oder Sensoren, die beispielsweise gegen das Fluid bereits abgedichtet sind, mittels eines Kabels oder einer flexiblen Folie elektrisch leitend mit dem Elektronikmodul verbunden sein. Der Bauraum ist somit reduziert gering und die Bauteile kostengünstig herstellbar.

Um eine verbesserte thermische Widerstandsfähigkeit zu erzeugen, ist gemäß einer die Erfindung weiterbildende Ausführungsform die erste Leiterplatte zur Trägerplatte, insbesondere mittels der Vergussmasse als Trägerbauteil, beabstandet mit einem Zwischenraum ausgebildet und insbesondere der Zwischenraum mit einem Kühlkörper und/oder einer Wärmeleitfolie ausgefüllt. Der Zwischenraum hat somit den Vorteil, einen thermischen Ausgleich zu schaffen, wobei ein Kühlkörper und/oder eine Wärmeleitfolie die im Gehäuse des Elektronikmoduls entstandene Wärme effizient herausführen und an die Umgebung abgeben.

Um die Kühlung noch effizienter auszugestalten, weist gemäß einer weiter bevorzugten Ausführungsform die Trägerplatte mindestens eine Aussparung zur Aufnahme eines Kühlkörpers oder eines Bauteilabschnitts einer Maschinenvorrichtung auf, die insbesondere von dem Elektronikmodul gesteuert wird.

Es versteht sich, dass die erste Leiterplatte ebenfalls mit separaten Steckverbindern und Sensoren außerhalb des Gehäuses ausgebildet sein kann, um ein kompaktes Elektronikmodul zu schaffen.

Gemäß einer die Erfindung weiterbildenden Ausführungsform sind bei einem kompakten Elektronikmodul auf der ersten Leiterplatte zwei separate mit einer Vergussmasse separat abgedichtete zwei zweite Leiterplatten angeordnet, die zwei abgeschlossene fluiddichte Gehäuse bilden. Somit kann gegebenenfalls eine Wärmeabführung von zwei verschiedenen Gehäusen unterschiedlich ausgebildet sein und ein Elektronikmodul mit mehreren Gehäusen, die verschiedene Funktionen und gegebenenfalls unterschiedliche thermische Belastungen aufweisen, kosteneffizient gefertigt werden.

Gemäß einer die Erfindung weiterbildenden Ausführungsform sind die Abstandshalter sowohl auf der ersten Leiterplatte als auch der Deckelplatte an komplementären Eckbereichen angeordnet. Eine derartige Ausführungsform kann Fertigungsvorteile mit sich bringen gegenüber Abstandshaltern, die einstückig die Beabstandung zwischen Deckelplatte und Leiterplatte definieren.

Gemäß einem weiteren Aspekt der Erfindung wird ein Verfahren zum Herstellen eines Elektronikmoduls mit einem fluiddichten Gehäuse mit oben beschriebenen Merkmalen geschaffen, wobei das Verfahren aufweist ein Bereitstellen einer Leiterplatte mit elektronischen Bauelementen, ein Bereitstellen von Abstandshaltern zumindest in Eckbereichen auf der Leiterplatte und ein Bereitstellen einer Deckelplatte auf den Abstandshaltern zur Beabstandung der Deckelplatte zu der Leiterplatte. Das Verfahren zeichnet sich insbesondere dadurch aus, dass eine Vergussmasse an den Außenkanten der Deckelplatte und auf der Leiterplatte zum stirnseitigen Abdichten und stoffschlüssigem Verbinden zwischen Deckelplatte, Leiterplatte und Abstandshaltern zu einem geschlossenen Gehäuse aufgetragen und ausgehärtet wird, wobei der thermische Längenausdehnungskoeffizient (CTE) von der Vergussmasse im Wesentlichen mit den thermischen Längenausdehnungskoeffizienten (CTE) von der Leiterplatte und der Deckelplatte übereinstimmt.

Somit ist ein kostengünstiges Herstellungsverfahren geschaffen, das einen geringen Fixkostenanteil aufweist und die Herstellungskosten im Wesentlichen die Materialkosten sowie variable Herstellungskosten sind. Die Fertigungskosten sind somit unabhängiger von den Stückzahlen und von der Geometrie des Elektronikmoduls. Es ergibt sich auch eine einfachere Montage. Ferner bietet das Aushärten der Vergussmasse gleichzeitig eine Temperierung der Schaltung als Voralterung der Elektronik (burn-in). Es kann auch während der Temperierung die Funktion und z.B. ein Hochtemperaturtest, parallel und ohne Zusatzaufwand geprüft werden. Ein zusätzliches Heizen für einen Test ist nicht mehr notwendig, weil er gleichzeitig das finale Aushärten des Vergusses mitumfasst. Hierbei wird nicht unbedingt eine Trägerplatte benötigt, da beispielsweise eine Modul-AVT auch direkt auf eine Maschinenvorrichtung, wie zum Beispiel ein Getriebeteil, montiert werden kann.

Es erfolgt ferner leicht eine einfache elektrische Integration in ein übergeordnetes Steuermodul. Die elektrische und elektronische Schaltung kann auf einer Leiterplatte angeordnet sein, wobei diese beispielsweise Bare-Die-geklebt oder wire-bonded oder gelötet auf einer Standardleiterplatte oder einer sogenannten HDI-PCB, das heißt High Density Interconnect PCB, ausgebildet sein kann. Gehäuste Bauelemente, Flip-Chip-Bauelemente, Ball Grid Array (BGA)-Bauelemente oder Wafer-Level-Package-Bauelemente auf PCB, HDI-PCB sind möglich. Auch ein Vergelen der elektronischen Schaltung, zum Beispiel via bonded Bare-Dies, ist realisierbar. Es besteht auch ein Schutz gegen Alphastrahlen. Gegebenenfalls ist eine dünne Lackschicht auf den Bauelementen oder auch als Unterfüllung bei BGA, Wafer-Level-Package-Bauelementen mit Standardmaterialien, die nicht getriebeölbeständig sein müssen, als Schutz möglich. Die Schaltung ist mittels der Leiterplatte und der Deckelplatte fluiddicht gesichert, wobei die Vergussmasse als Epoxidharzmasse als Damm aufgebracht wird und die Deckelplatte darauf aufgelegt wird. Weiter bevorzugt ist die Kontaktstelle der Deckelplatte zum Damm gegebenenfalls vorher mit einer dünnen Schicht mit dem gleichen Epoxidharz, das heißt der Vergussmasse, gegebenenfalls in einer höheren Viskosität versehen worden, um eine gute Benetzung zu erreichen und um zu erreichen, dass beim Fügen Epoxidharz auf Epoxidharz gefügt wird.

Die Vergussmasse kann als dünner hochviskoser Film auch auf die gesamte Deckelfläche der Deckelplatte als zusätzlicher Schutz aufgetragen werden. Während des Vernetzungsprozesses, zum Beispiel durch ein Ausheizen von 30 Minuten unter 140°C, wird der Innenraum der Schaltung durch ein später zu verschließendes Entlüftungsloch Druck ausgeglichen, damit kein Wegdrücken der Vergussmasse durch Innendruck erfolgt.

Es wird darauf hingewiesen, dass einige der möglichen Merkmale und Vorteile der Erfindung hierin mit Bezug auf unterschiedliche Ausführungsformen beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind. Es zeigen:
- Fig. 1: eine Querschnittsansicht gemäß einer ersten noch nicht zusammengebauten Ausführungsform eines Elektronikmoduls;
- Fig. 2: eine Draufsicht eines noch nicht zusammengebauten Elektronikmoduls;
- Fig. 3: eine Querschnittsansicht eines Elektronikmoduls mit einer Deckelplatte;
- Fig. 4: eine Draufsicht der in Fig. 3 gezeigten Figur;
- Fig. 5: eine Querschnittsansicht einer ersten Ausführungsform des erfindungsgemäßen Elektronikmoduls;
- Fig. 6: eine Querschnittsansicht des erfindungsgemäßen Elektronikmoduls gemäß Fig. 5 mit einer zusätzlichen Verstärkung;
- Fig. 7: eine Querschnittsansicht einer zweiten erfindungsgemäßen Ausführungsform des Elektronikmoduls;
- Fig. 8: eine Draufsicht des erfindungsgemäßen Elektronikmoduls gemäß Fig. 5 und 6;
- Fig. 9: eine Querschnittsansicht einer dritten Ausführungsform eines noch nicht zusammengebauten Elektronikmoduls;
- Fig. 10: eine Draufsicht des Elektronikmoduls gemäß Fig. 9;
- Fig. 11: eine Querschnittsansicht des fertig zusammengebauten Elektronikmoduls gemäß Fig. 9;
- Fig. 12: eine Draufsicht des in Fig. 11 gezeigten Elektronikmoduls;
- Fig. 13: eine Querschnittsansicht einer vierten erfindungsgemäßen Ausführungsform des Elektronikmoduls;
- Fig. 14: eine Querschnittsansicht einer alternativen Ausführungsform des Elektronikmoduls gemäß Fig. 13;
- Fig. 15: eine Querschnittsansicht einer alternativen Ausführungsform des Elektronikmoduls gemäß Fig. 13;
- Fig. 16: eine Querschnittsansicht von zwei einzeln bestückten Leiterplatten vor dem Zusammenbau;
- Fig. 17: eine Querschnittsansicht in einem folgenden Verfahrensschritt der in Fig. 1 gezeigten zwei Leiterplatten;
- Fig. 18: eine Querschnittsansicht im zusammengebauten Zustand eines erfindungsgemäßen Elektronikmoduls gemäß Fig. 16;
- Fig. 19: eine Querschnittsansicht einer alternative Ausführungsform zur in Fig. 17 gezeigten Vorstufe im Herstellungsverfahren des erfindungsgemäßen Elektronikmoduls;
- Fig. 20: eine Querschnittsansicht des zusammengebauten Elektronikmoduls analog zur Fig. 18;
- Fig. 21: eine Querschnittsansicht einer alternativen Ausführungsform zur Fig. 3 und 5;
- Fig. 22: eine Querschnittsansicht einer alternativen Ausführungsform zur Fig. 6;
- Fig. 23: eine Querschnittsansicht einer alternativen Ausführungsform zur Fig. 7;
- Fig. 24: eine alternative Ausführungsform des Elektronikmoduls im Querschnitt;
- Fig. 25: eine Querschnittsansicht von zwei bestückten Leiterplatten gemäß einer alternativen Ausführungsform zur Fig. 1 und 16;
- Fig. 26: eine Querschnittsansicht von einem zusammengebauten Elektronikmodul gemäß der Fig. 18;
- Fig. 27: eine Querschnittsansicht von einem zusammengebauten alternativen Elektronikmodul gemäß Fig. 26;
- Fig. 28: eine Querschnittsansicht von einem Elektronikmodul gemäß einer weiteren alternativen Ausführungsform;
- Fig. 29: eine Querschnittsansicht von zwei Leiterplatten gemäß einer alternativen Ausführungsform entsprechend zur Fig. 16; und
- Fig. 30: eine Querschnittsansicht von einem zusammengebauten Elektronikmodul gemäß der Fig. 23.

Die Figuren sind lediglich schematisch und nicht maßstabsgetreu abgebildet. Gleiche Bezugszeichen bezeichnen in den Figuren gleiche oder gleichwirkende Merkmale.

### Ausführungsformen der Erfindung

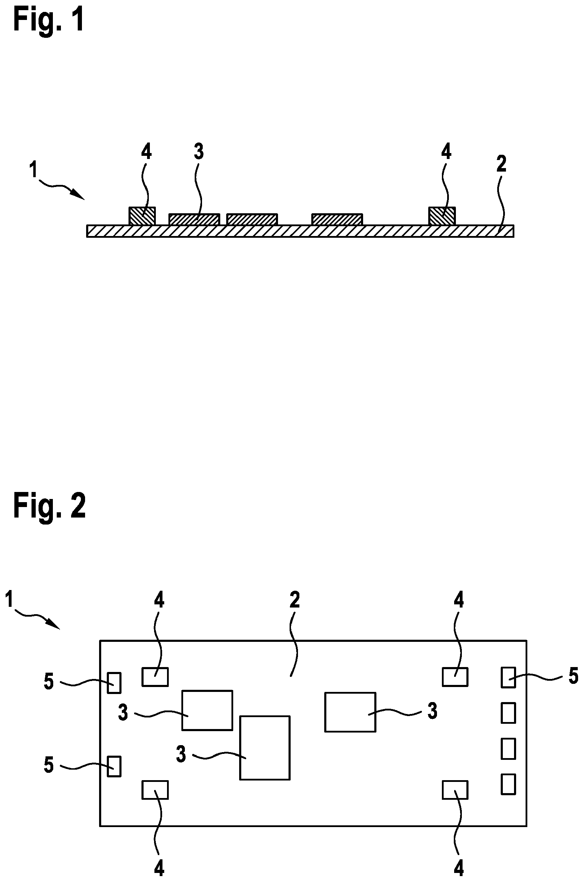

Die Fig. 1 zeigt im Querschnitt eine erste Stufe für den Zusammenbau eines erfindungsgemäßen Elektronikmoduls 1 bzw. für das Verfahren zum Herstellen eines Elektronikmoduls 1 mit einem fluiddichten Gehäuse 26. Hierfür ist das Bereitstellen einer Leiterplatte 2 mit darin angeordneten Kupferleiterbahnen erforderlich. Auf der Leiterplatte 2 sind elektronische Bauelemente 3 angeordnet. Diese Bauelemente 3 können SMD-Bauteile, verpackte Bauelemente als sogenannte ICs mit integrierten Schaltungen, aber auch Bare-Die-Elektronikbauteile sein. Da die Siliziumstrukturen nicht mit einer Mold-Masse, einer sogenannten Vergussmasse, umspritzt werden, können die Siliziumstrukturen der elektronischen Bauteile entsprechend der gegenwärtigen und zukünftigen Entwicklung weiter miniaturisiert ausgebildet sein, das heißt, die Abstände zwischen den Leiterbahnen können von 90 nm auf 40 oder 28 nm sinken und die Kontaktabstünde für Bonddrähte, Lötzinnpins oder Ball Grids können ohne Zusatzkosten von 50 µm auf z. B. 20 µm sinken. Ferner bestehen keine Gefahren aufgrund von Alphastrahlen, die durch mineralische Füllstoffe in der Vergussmasse herkömmlicherweise auftreten.

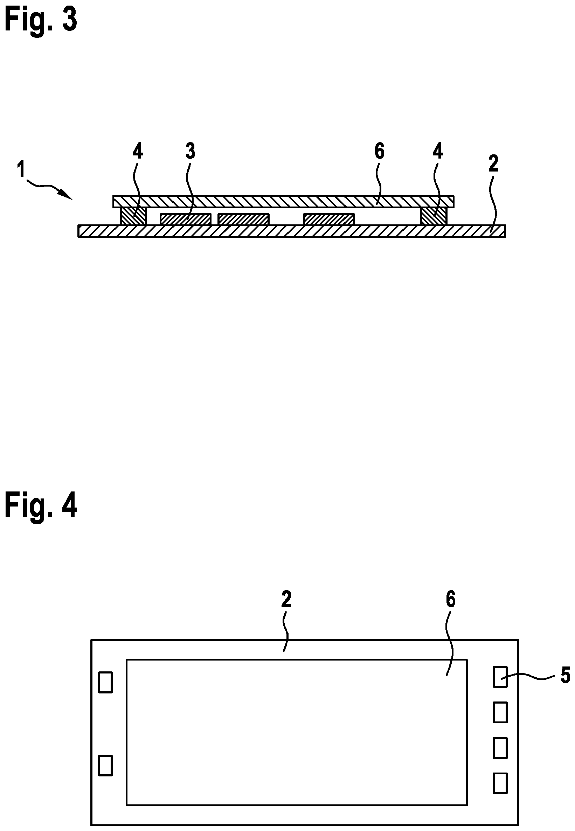

In dem Eckbereich der Leiterplatte 2 sind Abstandshalter 4 angeordnet. Diese Abstandshalter 4 weisen eine höhere Höhe als die auf der Leiterplatte 2 angeordneten elektronischen Bauelemente 3 auf, falls eine in der Fig. 3 und 4 und ff. folgende Deckelplatte 6 nicht direkt auf den Bauelementen 3 liegen darf.

Die Fig. 2 zeigt den Verfahrenszustand der Fig. 1 in einer Draufsicht von dem Elektronikmodul 1. In den Eckbereichen sind die vier Abstandshalter 4 angeordnet. In dem von den Abstandshaltern 4 aufgespannten Rechteck sind die elektronischen Bauelemente 3 angeordnet. Parallel zur Breite der Leiterplatte 2 sind auf der Leiterplatte 2 für elektrische Anschlüsse verzinnte Kupferkontaktflächen 5, sogenannte Pads, vorgesehen. Diese Kupferkontaktflächen 5 sind Anschlüsse für Steckverbinder und andere Sensoren bzw. Steuerungen. Da die Kupferkontaktplatten 5 verzinnt sind, sind sie gegenüber Fluiden, insbesondere einem Getriebeöl, in dem das Elektronikmodul 2 insbesondere lagerbar ist, alterungsbeständig.

Die Fig. 3 zeigt in entsprechender Weise zur Fig. 1 den nächsten Verfahrensschritt, das Bereitstellen einer Deckelplatte 6 auf den Abstandshaltern 4 zur Beabstandung der Deckelplatte zur Leiterplatte 2 und zum nachfolgenden Ausbilden eines Gehäuses 26.

Die Fig. 4 zeigt entsprechend zur Fig. 2 eine Draufsicht der Fig. 4, so dass in der Draufsicht lediglich die Leiterplatte 2 und an beiden breiten Seiten davon, die Deckelplatte 6 überstehend, jeweils die Kontaktflächen 5 sichtbar ausgebildet sind.

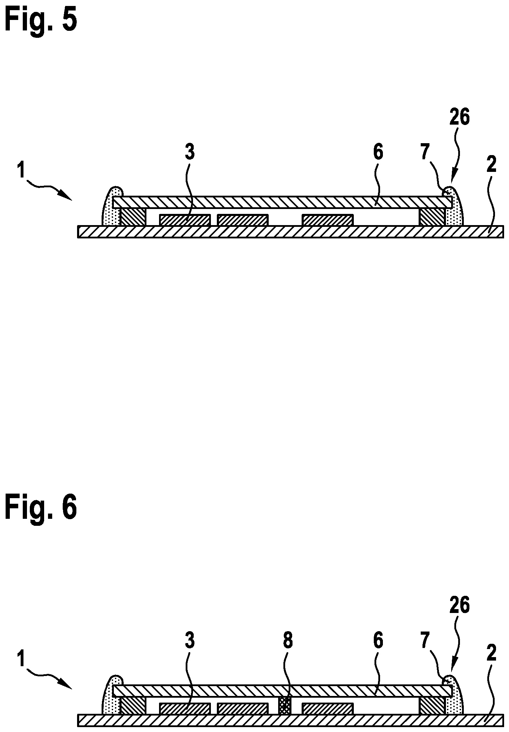

Die Fig. 5 zeigt in einer Querschnittansicht das erfindungsgemäße Elektronikmodul 1 mit einem vollendeten letzten Verfahrensschritt entsprechend den Verfahrensschritten zur Fig. 1 und 3 folgend. Die Verfahrensschritte zum Herstellen des erfindungsgemäßen Elektronikmoduls 1 vom Zustand der Fig. 3 zur Fig. 5 sind das Auftragen einer Vergussmasse 7 an der umlaufenden Kante der Deckelplatte 6, so dass ein abdichtender Damm (dam) als stirnseitiger Verschluss durch die Vergussmasse 7 zwischen der Leiterplatte 2 und der Deckelplatte 6 entsteht, der die darin angeordneten elektronischen Bauelemente 3 in Form eines Gehäuses 26 fluiddicht schützt.

Im Gegensatz zum Stand der Technik gemäß der DE 10 2013 215 246 ist es nicht mehr erforderlich, eine umlaufende Mikrostrukturierung an beiden Leiterplattenelementen vorzusehen, um eine formschlüssige, verkrallende Verbindung zu schaffen.

Es ist erfindungsgemäß überraschenderweise herausgefunden worden, dass die Vergussmasse bevorzugt aus einem duroplastischen Kunststoff, insbesondere einem Epoxidharz, ausreicht, um die Deckelplatte an der Leiterplatte beabstandet stoffschlüssig zu sichern. Wichtig ist hierfür, dass der thermische Längenausdehnungskoeffizient (CTE) von der Vergussmasse im Wesentlichen mit den thermischen Längenausdehnungskoeffizienten (CTE) von der Leiterplatte und der Deckelplatte übereinstimmt. Eine aufwändige Einbringung von Mikrostrukturierungen ist deshalb nicht mehr notwendig, die zu einem mechanischen Verkrallen bisher erforderlich waren. Allein durch die geeignete Auswahl der Vergussmasse 7 wird ein stoffschlüssiges adhäsives Verhalten erzeugt, das auch thermischen mechanischen Belastungen standhält. Das Elektronikmodul 1 ist zum Teil sehr hohen Temperaturschwankungen unterworfen, die im Bereich von -40 bis 150°C und mehr liegen können. Trotzdem werden Rissbildungen vermieden, denn gemäß der Erfindung ist der thermische Längenausdehnungskoeffizient für die das Gehäuse 26 bildenden Bauteile im Wesentlichen übereinstimmend. Der thermische Längenausdehnungskoeffizient (CTE) kann zwischen dem CTE der Vergussmasse und dem CTE der Leiterplatte sowie dem CTE der Deckelplatte maximal im Bereich von 5-10 ppm/K abweichen, um noch eine ausreichende Temperaturbeständigkeit zu erreichen.

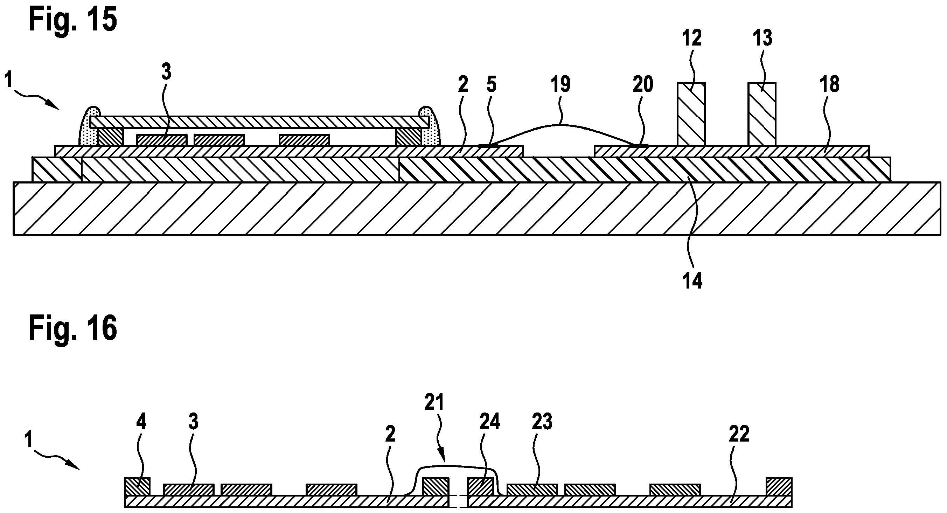

Bevorzugt ist die Deckelplatte 6 ebenfalls, wie in den Fig. 16 ff. beschrieben wird, eine zweite Leiterplatte. Die Vergussmasse 7 hat einen thermischen Längenausdehnungskoeffizienten von ca. 20 ppm/K, wenn dies ein mit mineralischen Füllstoffen gefülltes Epoxidmaterial bzw. Epoxidwerkstoff ist. Eine starre Leiterplatte hat einen thermischen Längenausdehnungskoeffizienten CTE von ca. 18 ppm/K. Leichter und etwas kostengünstiger wäre eine Deckelplatte 6 aus Aluminium mit einem thermischen Längenausdehnungskoeffizienten von 23 ppm/K und noch etwas kostengünstiger wäre eine Deckelplatte 6 aus einem Stahlwerkstoff mit einem thermischen Längenausdehnungskoeffizienten CTE von 11 bis 20 ppm/K je nach Legierung, wenn höhere Ni-Legierungsanteile dabei sind, sogar bis 20 ppm/K. Wenn die Deckelplatte 6 eine Epoxidharzplatte ist, kann diese aus zum Beispiel Leiterplatten-Pre-Pregs oder Leiterplatten-Kernen hergestellt sein ohne eine Schaltungsverdrahtung. Die Anzahl der verwendeten Pre-Pregs oder Kerne richtet sich nach der benötigten Steifigkeit der Deckelplatte 6, die aber auch zusätzlich in der Mitte, beispielsweise mit einer Zusatzklebung 8, wie in der Fig. 6 gezeigt, verstärkt ausgeführt sein kann.

Die Fig. 5 und 6 zeigen im Querschnitt gesehen ferner, dass die Vergussmasse 7 den Außenumfang der Deckelplatte 6 übergreifend erfasst. Dies ist vorteilhaft, da beispielsweise ein ölhaltiges Fluid, beispielsweise in einem automatischen Getriebe, ca. 0,5 mm tief in eine Leiterplatte 2 eindringen kann. Mit einer wie in der Fig. 5 und 6 gezeigten Überlappung der Vergussmasse 7 wird somit ein tieferes Eindringen an dem Außenumfang vermieden.

Aufgrund der Schaffung eines fluiddichten Gehäuses 26 ist es somit möglich, sowohl gehäuste Bauelemente als Flip-Chip, BGA oder Wafer-Level-Package oder Bare-Die-geklebt oder wire-bonded einfach auf der Leiterplatte 2 zu fixieren, ohne besondere Vorkehrungen zusätzlich gegen das äußere Fluid aufbringen zu müssen. Zusätzliche Spanschutzvorrichtungen sind nicht mehr notwendig. Ferner sind bei einem derartigen Gehäuse 26 die Fixkosten äußerst niedrig, da das Gehäuse 26 im Wesentlichen aus Standardkomponenten hergestellt wird. Im Wesentlichen fallen nur variable Kosten an, die unabhängig von der Stückzahl sind, wobei die Form des Gehäuses 26 frei definierbar ist. Die Darstellung in Rechtecken, wie in der Fig. 1 bis 6 dargestellt, insbesondere in den Draufsichten Fig. 2, 4 und 8, dient nur als besonderes bevorzugtes Beispiel.

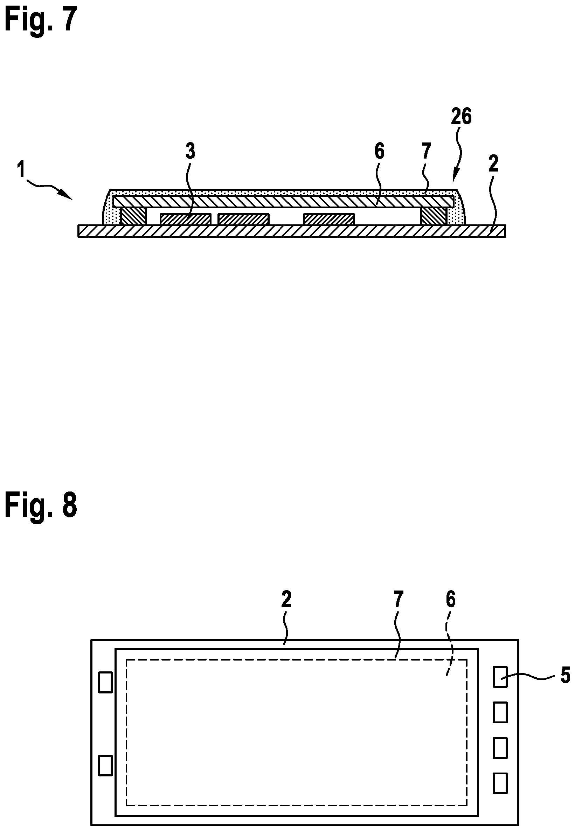

Die Fig. 7 zeigt eine weitere besondere Ausführungsform, bei der die Deckelplatte 6 vollständig mit der Vergussmasse 7 über die gesamte äußere Fläche bedeckt ist. Diese Abdeckung kann eine relativ dünne Schicht von ca. 0,2 mm sein. Somit wird ein Eindringen eines beispielweise aggressiven Getriebeöls noch besser verhindert. Die Epoxidharz-Vergussmasse 7 ist sehr kostenintensiv. Deshalb ist ein sehr ressourcenschonender Umgang empfehlenswert.

Die Fig. 8 zeigt eine Draufsicht der Fig. 5 und 6. Die Deckelplatte 6 weist an ihrem äußeren Umfang die übergreifende Vergussmasse 7 auf und an den breiten Seiten der rechteckförmigen Leiterplatte 5 sind die Kupferkontaktplatten 5 angeordnet.

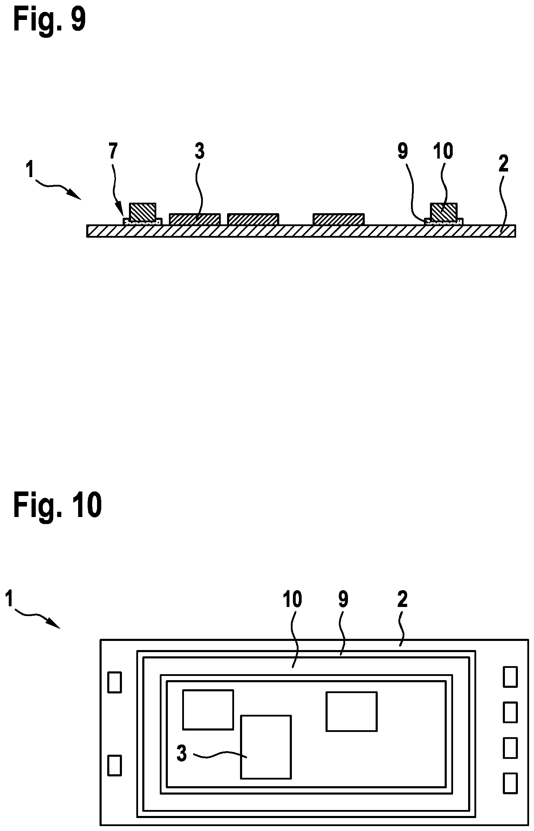

Die Fig. 9 zeigt im Querschnitt gesehen einen ersten Verfahrensschritt zur Herstellung eines erfindungsgemäßen Elektronikmoduls 1 mit einem fluiddichten Gehäuse 26, bei dem die Leiterplatte 2 bereitgestellt ist. Elektronische Bauelemente 3 sind auf der Leiterplatte 2 bereits angeordnet.

In einem Rechteck ist um die elektronischen Bauelemente 3 ein Wulst 9 der Vergussmasse 7 rechteckförmig auf der Leiterplatte 2, wie in der Fig. 10 in der Draufsicht gezeigt, angeordnet. Auf den rechteckförmigen Wulst 9 der Vergussmasse 7 ist ein Abstandhaltering 10 aufgesetzt, so dass der Abstandhaltering 10 über den Wulst 9 der Vergussmasse 7 mit der Leiterplatte 2 fluiddicht durch Aushärten der Vergussmasse 7 verklebt wird. Es versteht sich, dass der Wulst 9 der Vergussmasse 7 auch einen Vergussmassefilm umfassen kann, wenn das Elektronikmodul 1 äußerst materialsparend hergestellt werden soll. Der Abstandhaltering 10 umfasst somit die in den vorherigen Figuren beschriebenen Abstandshalter 4 und ersetzt diese somit.

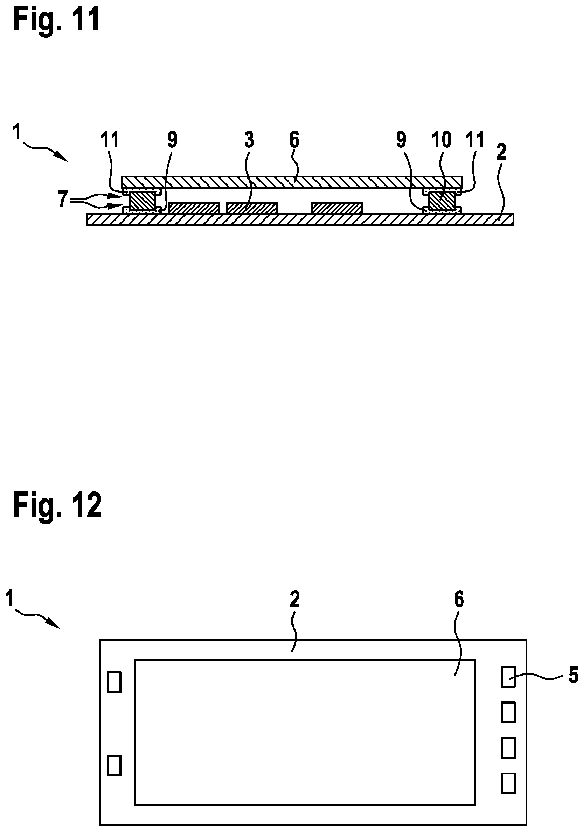

Wie in der Fig. 11 gezeigt ist, ist auf den Abstandhaltering 10 ebenfalls ein Wulst 11 der Vergussmasse 7, also auf der gegenüberliegenden Oberfläche, aufgetragen, so dass eine fluiddichte Verklebung zwischen Oberseite des Abstandhalterings 10 und der Deckelplatte 6 realisiert ist. Somit ist stirnseitig eine Abdichtung des Gehäuses 26 wie in den vorher beschriebenen Fig. 1 bis 8 geschaffen worden, wobei eine deutlich geringere Menge an Vergussmasse 7 notwendig ist. Solche Ausführungsformen sind wichtig, da die Vergussmasse 7 sehr kostenintensiv im Gegensatz zu einem Abstandhaltering 10 ist. Der Abstandhaltering 10 weist bevorzugt ein geschlossenes Rechteckprofil auf, das wiederum bevorzugt in der Draufsicht, wie in der Fig. 10 zu sehen, rechteckförmig ausgebildet ist. Die Querschnitte des Abstandhalterings 10 sind in den Fig. 9 und 11 dargestellt und zeigen dort das Rechteckprofil des Abstandhalterings 10.

Die Fig. 12 ist eine korrespondierende Ansicht zur Fig. 8 mit einer Draufsicht des gemäß Fig. 11 fertig zusammengebauten Elektronikmoduls 1. Somit sind lediglich die Leiterplatte 2, die Deckelplatte 6 und die Kupferkontaktplatten 5 sichtbar.

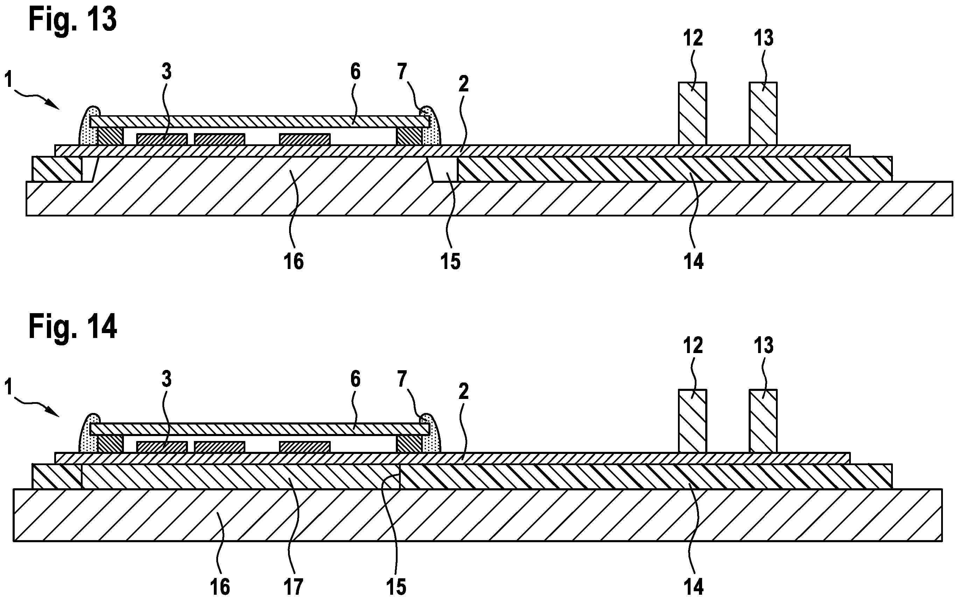

Die Fig. 13 zeigt eine weitere besondere Ausführungsform des erfindungsgemäßen Elektronikmoduls 1. Bei diesem Elektronikmodul 1 sind nicht nur die Steuerelektronik auf der Leiterplatte 2 angeordnet, sondern zusätzlich auch Sensoren 12 und Steckverbinder 13. Somit ist das Elektronikmodul 1 als integriertes Elektronikmodul ausgebildet. Hierfür ist die Leiterplatte 2 vergrößert d.h. verlängert ausgebildet, so dass auf einer Seite Platz für Sensoren 12 und Steckverbinder 13 und auf der anderen Seite das Gehäuse 26 vorgesehen ist. Ferner ist beispielsweise aus Kunststoff eine Trägerplatte 14 vorgesehen, auf der die Leiterplatte 2 mit dem Elektronikmodul 1 angeordnet ist. Die Trägerplatte 14 weist eine Aussparung 15 auf, insbesondere im Bereich der Leiterplatte 2, wo die Bauelemente 3 auf der Oberseite der Leiterplatte 2 angeordnet sind. Hier greift beispielsweise ein Getriebegehäusebauteil 16 in die Aussparung 15 ein und führt somit die von den elektronischen Bauelementen 3 erzeugte Wärme über die Leiterplatte 2 an deren Unterseite direkt zum Getriebegehäusebauteil 16 ab. Die Trägerplatte 14 überbrückt die Distanz zur Leiterplatte 2 im Bereich der angeordneten Sensoren 12 und der Steckverbinder 13. Hier ist eine Wärmeentwicklung deutlich geringer.

Die Fig. 14 zeigt eine alternative Ausführungsform zur Fig. 13. Bei dieser Ausführungsform weist die Trägerplatte 14 wieder eine Aussparung 15 auf, wobei die Aussparung 15 durch einen eingelegten Kühlboden 17 als Kühlkörper ausgefüllt ist. Dies hat den Vorteil, dass die Außenwand des Getriebegehäusebauteils 16 für die Aussparung 15 keine besondere Erhöhung ausgebildet haben muss. Vielmehr kann das Getriebegehäusebauteil 16 einheitlich mit einer gleichen Wandstärke in einfachen Formen gebaut sein. Die Aussparung 15 kann somit individuell mit einem entsprechenden Kühlboden 17 konstruiert werden.

Die Fig. 15 zeigt im Querschnitt eine weitere alternative Ausführungsform zur Fig. 14. Bei dieser Ausführungsform ist im Unterschied zur Fig. 14 die Leiterplatte 2 geteilt ausgebildet. Die Leiterplatte 2 umfasst das Elektronikmodul 1 mit den elektronischen Bauteilen 3 auf der Oberseite der Leiterplatte 2 angeordnet. Eine weitere Leiterplatte 18 ist auf der Trägerplatte 14 angeordnet, die die Sensoren 12 und Steckverbinder 13 umfasst. Elektrische Kabel 19, die beispielsweise durch einen Lack geschützt sind, oder flexible Kabel verbinden die Leiterplatte 2 mit der Leiterplatte 18 an elektrischen Kontakten 25, um elektrisch leitende Leitungen zwischen dem Steckverbinder 13 und den Sensoren 12 zu schaffen.

Die Fig. 16 zeigt im Querschnitt gesehen entsprechend zur Fig. 1 eine weitere besondere Ausführungsform des erfindungsgemäßen Elektronikmoduls 1, bei dem zusätzlich zur ersten Leiterplatte 2 eine weitere, zweite Leiterplatte 22 mit elektrischen Bauelementen 23 und Abstandshaltern 24 in den Eckbereichen vorgesehen ist. Die Fig. 16 zeigt das Elektronikmodul 1 im noch nicht zusammengebauten Zustand entsprechend zur Fig. 1 in der Querschnittansicht. Die beiden Leiterplatten 2 und 22 können ursprünglich einstückig hergestellt sein und in einem weiteren Fertigungsschritt getrennt werden bzw. gebrochen werden oder zerschnitten werden. Oder die beiden Leiterplatten 2, 22 werden separat hergestellt und dann, wie in Fig. 16 gezeigt, in einem Verfahrensschritt bereitgestellt. Die beiden Leiterplatten 2, 22 sind mittels eines elektronischen Kabels 21 oder einer flexiblen Folie, zum Beispiel FR4-Flexleiter, miteinander verbunden, so dass die elektronischen Bauelemente 3, 23 miteinander im Betrieb arbeiten können. Somit ist das Elektronikmodul 1 äußerst platzsparend herstellbar. Am Außenrand gibt es keine elektrischen Kontakte, so dass eine Gefahr des Eindringens von aggressiven Fluiden, wie beispielsweise Automatikgetriebeöl, nicht bestehen und kein Schaden entstehen kann.

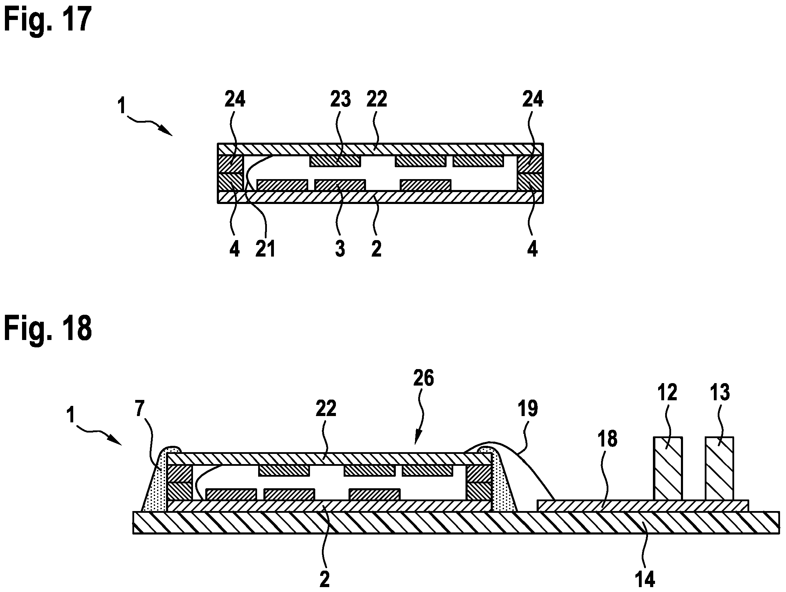

Die Fig. 17 zeigt einen weiteren Verfahrensschritt, der Fig. 16 folgend. In diesem Verfahrensschritt ist die erste Leiterplatte 2 als Basis liegend angeordnet und die zweite Leiterplatte 22 ist gegenüber der in Fig. 16 um 180° gedreht auf den Abstandshaltern 4, 24 in den Eckbereichen auf der ersten Leiterplatte 2 aufliegend angeordnet. Die elektrischen Bauelemente 3, 23 weisen somit zu einem Gehäuseinneren. Das Gehäuseinnere wird durch die erste Leiterplatte 2 und die zweite Leiterplatte 22 sowie der Vergussmasse 7, wie in der Fig. 18 gezeigt ist, gebildet.

Die Fig. 18 zeigt eine zur Fig. 15 entsprechende Querschnittsansicht, mit dem Unterschied, dass das Elektronikmodul 1, wie in den Verfahrensschritten in Fig. 16 und 17 vorbereitend gezeigt ist, zu einem Gehäuse 26 zusammengebaut ist. Separat ist eine dritte Leiterplatte 18 für Sensoren 12 und Steckverbinder 13 auf einer Trägerplatte 14 angeordnet. Die zweite Leiterplatte 22 liegt direkt auf der Trägerplatte 14 auf und die Vergussmasse 7 verbindet sowohl die erste Leiterplatte 2 mit der zweiten Leiterplatte 22 im Außenumfang umgreifend als auch die Trägerplatte 14. Da zumindest die beiden Leiterplatten 2, 22 und die Vergussmasse 7 einen thermischen Längenausdehnungskoeffizienten (CTE) aufweisen, der jeweils im Wesentlichen übereinstimmt, treten aufgrund thermischer Belastungen keine Risse auf. Eine stoffschlüssige Verbindung ist ausreichend und ein zusätzliches Verkrallen aufgrund eines Formschlusses ist somit nicht mehr notwendig, das heißt eine aufwändige Vorbearbeitung der Leiterplatten 2, 22 sowie der Trägerplatte 14 entfällt erfindungsgemäß.

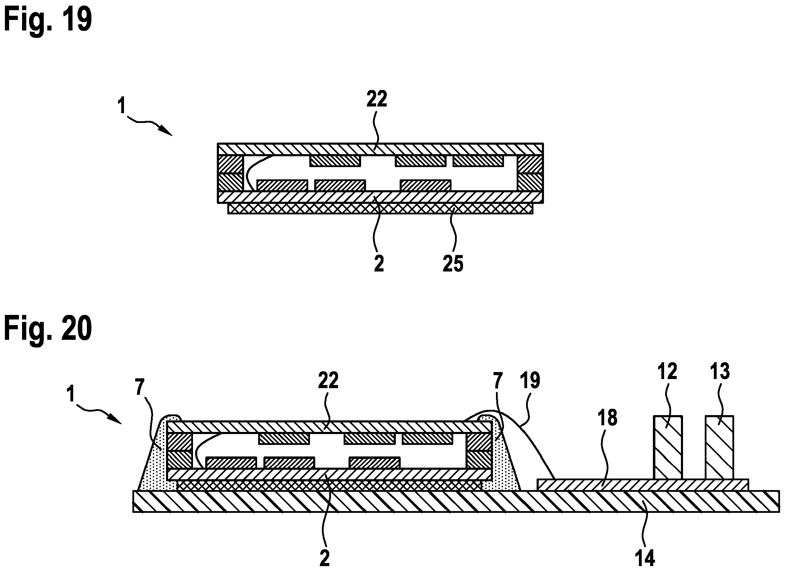

Die Fig. 19 zeigt eine zur Fig. 17 entsprechende Querschnittsansicht des in der Herstellung befindlichen Elektronikmoduls 1 mit dem einzigen Unterschied, dass unter der elektrischen Leiterplatte 2 eine Wärmeleitfolie 25 oder Wärmepaste aufgetragen ist. Somit ist vergleichbar zur Fig. 15 statt eines Kühlbodens 17 die erste Leiterplatte 2 gegenüber der Trägerplatte 14 erhöht, wobei die Beabstandung der ersten Leiterplatte 2 zur Trägerplatte 14, wie in der Fig. 20 gezeigt ist, durch die Vergussmasse 7 beabstandet gehalten wird.

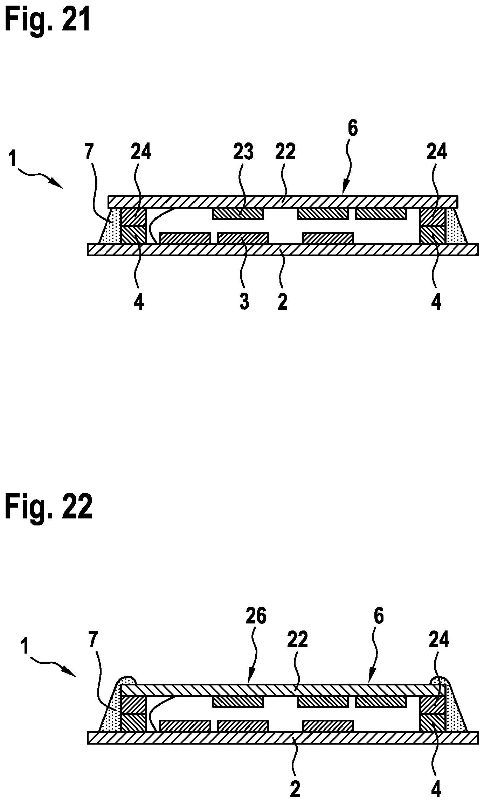

Die Fig. 21 zeigt eine alternative Ausführungsform des erfindungsgemäßen Elektronikmoduls 1 zu den vorher beschriebenen Ausführungsformen der Fig. 1 bis 20. Bei dieser Ausführungsform ist die Vergussmasse 7 äußerst ressourcenschonend eingesetzt. Die Vergussmasse 7 wird lediglich im Querschnitt gesehen in einem Kanal zwischen erster Leiterplatte 2 und zweiter Leiterplatte 22 als Deckelplatte 6 sowie den Abstandshaltern 24, 4 aufgetragen und ausgehärtet. Die Vergussmasse 7 überdeckt somit den äußeren Umfangsrand der Deckelplatte 6 bzw. der zweiten Leiterplatte 22 nicht. Lediglich die Stirnseiten des von den Leiterplatten 2, 22 geschaffenen Gehäuses 26 vom Elektronikmodul 1 sind mittels der Vergussmasse 7 ausgefüllt. Die stoffschlüssigen Adhäsionskräfte der Vergussmasse 7 mit der ersten Leiterplatte 2 und der zweiten Leiterplatte 22 reichen zur fluidgeschützten Sicherung des Gehäuses 26 aus. Die elektronischen Bauelemente 3, 23 können, wie vorher beschrieben, mit hohen Mikrostrukturauflösungen bezüglich Draht- und Leiterbahnabständen hergestellt sein und müssen nicht oder nicht mehr zusätzlich gegen ein aggressives Fluidmedium geschützt werden.

Die Fig. 22 zeigt dagegen eine zur Fig. 18 entsprechende Ausführungsform, bei der lediglich die erste Leiterplatte 2 eine größere Fläche als die zweite Leiterplatte 22 besitzt, wobei die Abstandshalter 4, 24 gegenüber der zweiten Leiterplatte 22 als Stufe im Außenumfang vorstehend angeordnet sind und von der Vergussmasse 7 zu einem glatten äußeren Außenumfang abgedichtet sind. Die Vergussmasse 7 umgreift auch hier wieder, wie in der Fig. 18, 20, 5, 6, 7, 13, 14 und 15 gezeigt, den äußeren Umfangsrand der zweiten Leiterplatte 22, die als Deckelplatte 6 wirkt.

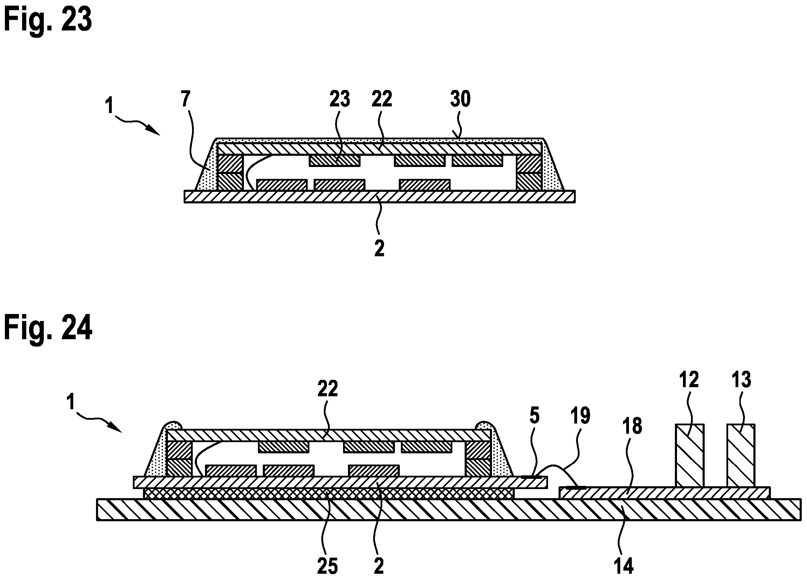

Die Fig. 23 zeigt eine weitere besondere Ausführungsform des erfindungsgemäßen Elektronikmoduls 1. Bei diesem Elektronikmodul 1 überzieht die Vergussmasse 7 die gesamte Oberfläche der Deckelplatte 6, die hier in diesem Fall als zweite Leiterplatte 22 ausgebildet ist. Dies hat den Vorteil, dass durch die Leiterplatte 22 durchgehende Anschlusspins auf der Oberseite von auf der Unterseite angeordneten elektronischen Bauelementen 23 gegenüber Fluiden abgedichtet sind. Die äußere Schichtdicke der Vergussmasse 7 auf der zweiten Leiterplatte 22 kann ressourcenschonend minimal klein sein. Erfindungsgemäß ist herausgefunden worden, dass Schichtdicken von 0,2 mm ausreichend ist.

Die Fig. 24 zeigt eine weitere besondere Ausführungsform entsprechend zur Fig. 20 und 22. Hier sind also die Ausführungsformen der Fig. 22 und 20 miteinander kombiniert. Die erste Leiterplatte 2 ist, wie in der Fig. 22 dargestellt, mit einer größeren Grundfläche als die zweite Leiterplatte 22 ausgebildet und ist als Elektronikmodul 1, wie in der Fig. 22 gezeigt, auf eine Wärmeleitfolie 25 oder Wärmeleitpaste 25 gelegt, die wiederum auf der Trägerplatte 14 angeordnet ist. Die dritte Leiterplatte 18 mit dem Steckverbinder 13 und den Sensoren 12 sind separat auf der Trägerplatte 14 angeordnet. Mittels des Kabels 19 sind elektrische Leitungen an den Kontaktplatten 5 elektrisch leitend verbunden.

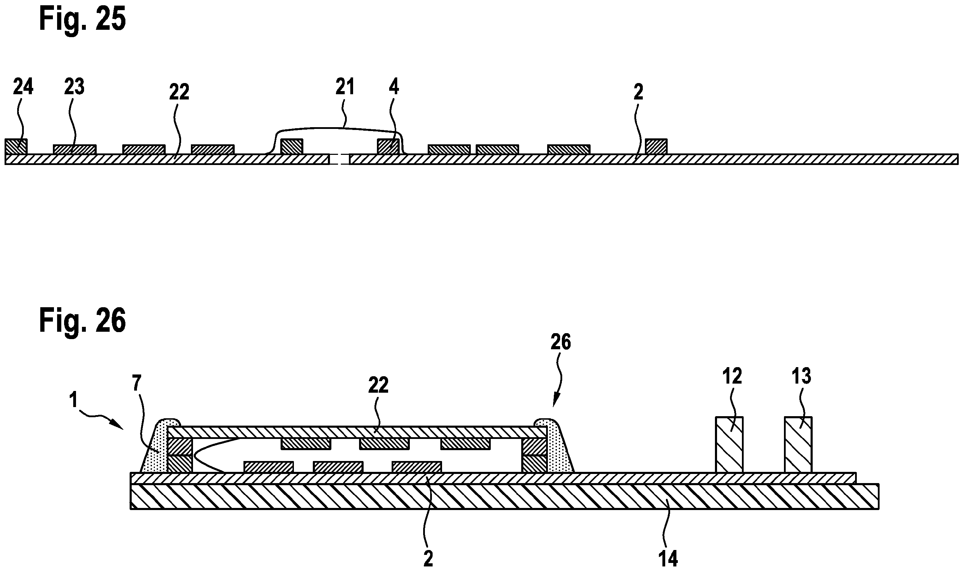

Die Fig. 25 zeigt eine zur Fig. 16 und 13 entsprechende Querschnittsansicht, bevor eine Vergussmasse 7, wie in der Fig. 26 gezeigt ist, als stirnseitiger Abschluss zur Bildung eines fluiddichten Gehäuses 26 aufgetragen und ausgehärtet ist. Hier ist die Leiterplatte 2, wie in der Fig. 13 gezeigt, großflächig angeordnet, wobei die zweite Leiterplatte 22 als Deckel 6 wirkend eine kleinere Arbeitsfläche besitzt. Mittels einer flexiblen Kabelfolie sind die beiden Leiterplatten 2, 22 elektrisch leitend miteinander verbunden.

Die Fig. 26 zeigt im Querschnitt gesehen das zusammengebaute Elektronikmodul 1, wobei die zweite Leiterplatte 22 wie in den vorherigen Figuren dargestellt auf einer Trägerplatte 14 montiert ist. Außerhalb des Gehäuses sind der Steckverbinder 13 und Sensoren 12 auf der ersten Leiterplatte 2 angeordnet.

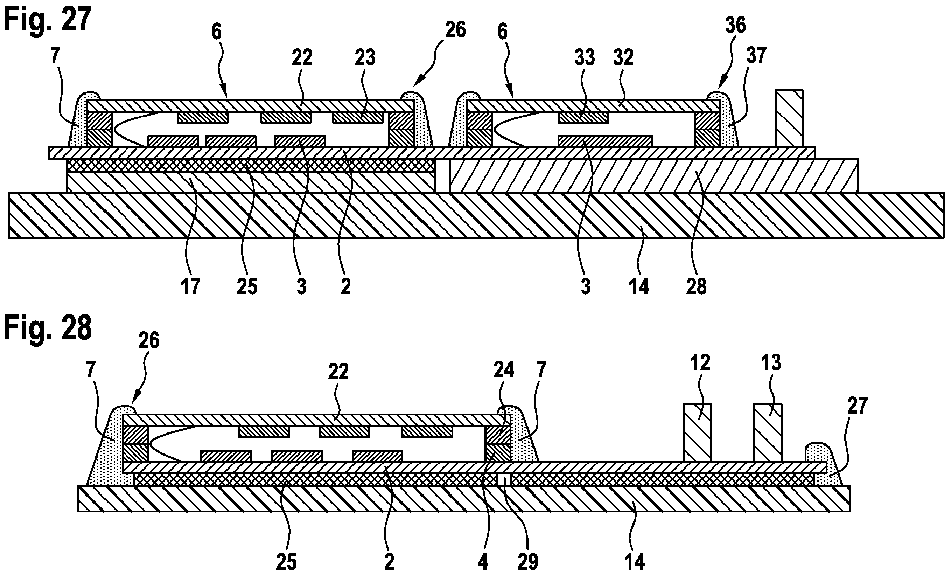

Die Fig. 27 zeigt eine weitere besondere Ausführungsform, die die Ausführungsform der Fig. 26 weiterbildet. Hier sind im Gegensatz zur Fig. 26 zwei separate Gehäuse 26, 36 angeordnet, wobei beide Gehäuse 26, 36 die erste Leiterplatte 2 als gemeinsame Bodenplatte haben mit jeweils elektronischen Bauelementen 3 auf deren Oberseite. Das erste Gehäuse 26 hat als Deckelplatte 6 die zweite Leiterplatte 22 mit elektronischen Bauteilen 23 und das zweite Gehäuse 36 hat eine vierte Leiterplatte 32 als Deckelplatte 6 mit elektronischen Bauteilen 33 auf deren Unterseite. Die Bauelemente 3, 23 des ersten Gehäuses 26 erzeugen eine höhere Wärme als die elektronischen Bauteile 3, 33 des zweiten Gehäuses 36. Unter dem Gehäuse 26 von der Leiterplatte 2 ist aus diesem Grund eine Wärmeleitfolie 25 angeordnet und ein zusätzlicher Kühlboden 17 folgend, der wiederum auf einer Trägerplatte 14 bzw. einem Getriebegehäusebauteil 16 oder einem Gehäusebauteil 16 angeordnet ist. Eine Kunststoffdistanzplatte 28 ist unter dem zweiten Gehäuse 36 angeordnet.

Die Fig. 28 zeigt eine weitere besondere Ausführungsform der Fig. 26 entsprechend der Fig. 24. Bei dieser Ausführungsform ist die erste Leiterplatte 2, wie in der Fig. 24 gezeigt, auf einer Wärmeleitfolie 25 angeordnet, wobei die Distanz, wie in der Fig. 20 dargestellt, beabstandet mittels der Vergussmasse 7 gehalten wird. Zusätzlich ist hier durch eine Vergussmasse 27 auch der Abschnitt der Leiterplatte 2 beabstandet zur Trägerplatte oder einem Gehäusebauteil angeordnet, wobei auch hier die Wärmeleitfolie 25 in diesem Bereich dazwischen liegend angeordnet ist. Zur Verstärkung ist ein Zwischenhalter 29 mittig an der Unterseite der Leiterplatte 2 in Verlängerung der Vergussmasse 7 und der Abstandshalter 4, 24 angeordnet.

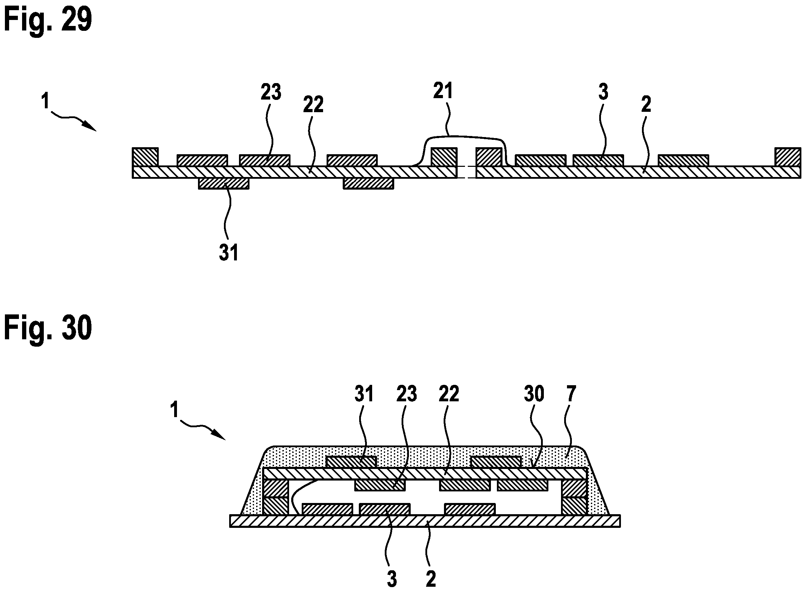

Die Fig. 29 zeigt entsprechend zur Fig. 25 und Fig. 1 die erste Leiterplatte 2 und eine daran entweder aufgrund eines Trennungsvorgangs davon abgetrennte zweite Leiterplatte 22 oder eine separat hergestellte Leiterplatte 22 mit dem Unterschied, dass die zweite Leiterplatte 22 nicht nur auf der Unterseite elektronische Bauelemente 23 aufweist, sondern auch auf deren Oberseite elektronische Bauelemente 31 angeordnet sind. Beide Leiterplatten 2, 22 sind in den vorher genannten gezeigten Figuren mittels eines flexiblen Leiterkabels 21 miteinander verbunden.

Die Fig. 30 zeigt den zusammengebauten Zustand des Elektronikmoduls 1, des in Fig. 29 dargestellten vorbereiteten Elektronikmoduls 1. Dieses Elektronikmodul 1 gemäß Fig. 30 zeigt die Besonderheit, dass die Vergussmasse 7 die äußere Oberflächenseite 30 der zweiten Leiterplatte 22 auch vollständig überdeckt wie auch die elektronischen Bauelemente 31 auf der Außenseite der zweiten Leiterplatte 22. Bei der Fig. 30 ist die Vergussmasse 7 bezüglich des Überzugs in einem übertriebenen Zustand dargestellt. Aufgrund einer ressourcenschonenden Materialverwendung der Vergussmasse 7 reicht es möglicherweise aus, einen sehr dünnen Film über die Oberfläche 30 und die elektronischen Bauteile 31 ausbilden in der Größenordnung von wenigen Millimetern oder Zehntel Millimetern.

Abschließend ist darauf hinzuweisen, dass Begriffe wie "aufweisend", "umfassend" etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Elektronikmodul (1) aufweisend:
eine erste Leiterplatte (2) mit elektronischen Bauelementen (3), Abstandshalter (4), die zumindest in Eckbereichen der ersten Leiterplatte (2) aufliegend angeordnet sind,
eine Deckelplatte (6), wobei die Deckelplatte (6) auf den Abstandshaltern (4) angeordnet ist,
eine Vergussmasse (7), die als stirnseitiger Verschluss eine durch die Abstandshalter (4) erzeugte Beabstandung zwischen Leiterplatte (2) und Deckelplatte (6) zu einem Gehäuse (26) für die darin angeordneten elektronischen Bauelemente (3) abdichtet,
wobei die Vergussmasse (7) stoffschlüssig die Deckelplatte (6) an der Leiterplatte (2) sichert, **dadurch gekennzeichnet, dass** der thermische Längenausdehnungskoeffizient (CTE) von der Vergussmasse (7) in soweit mit den thermischen Längenausdehnungskoeffizienten (CTE) von der Leiterplatte und der Deckelplatte (6) übereinstimmt, dass die Abweichung des thermischen Längenausdehnungskoeffizienten (CTE) zwischen dem CTE der Vergussmasse (7), dem CTE der Leiterplatte und dem CTE der Deckelplatte (6) max. 10 ppm/K beträgt,
wobei die Vergussmasse (7) auf einer Trägerplatte (14) angeordnet ist und insbesondere die erste Leiterplatte (2) direkt auf der Trägerplatte (14) aufliegend angeordnet ist, wobei weiter bevorzugt ein Kabel (19) an der äußeren Oberseite der Deckelplatte (6) zu einem elektrischen Anbauteil einer dritten Leiterplatte (18) auf der Trägerplatte (14) liegend angeordnet ist, wobei besonders bevorzugt die erste Leiterplatte (2) zur Trägerplatte (14), insbesondere mittels der Vergussmasse (7) als Trägerbauteil, beabstandet mit einem Zwischenraum ausgebildet ist und insbesondere der Zwischenraum mit einem Kühlkörper und/oder einer Wärmeleitfolie (25) ausgefüllt ist.

2. Elektronikmodul (1) nach Anspruch 1, **dadurch gekennzeichnet, dass** die Vergussmasse (7) einen thermischen Längenausdehnungskoeffizienten (CTE) von zwischen 8 ppm/K und 33 ppm/K, vorzugsweise zwischen 13 ppm/K und 28 ppm/K, stärker bevorzugt zwischen 13 ppm/K und 23 ppm/K, insbesondere 20 ppm/K, aufweist.

3. Elektronikmodul (1) nach Anspruch 2, **dadurch gekennzeichnet, dass** die Leiterplatte (2) mit einem CTE von 18 ppm/K ausgebildet ist, wobei die Deckelplatte (6) aus Stahl je nach Legierung von Ni-Stählen mit einem CTE zwischen 11 bis 20 ppm/K oder aus Aluminium mit einem CTE bei 23 ppm/K oder aus Epoxidharz mit einem CTE um 20 ppm/K hergestellt ist.

4. Elektronikmodul (1) nach einem der vorherigen Ansprüche 1 bis 3, **dadurch gekennzeichnet, dass** die Vergussmasse (7) ein Epoxidharz aus der Gruppe der aminisch härtenden Epoxide umfasst.

5. Elektronikmodul (1) nach einem der vorherigen Ansprüche 1 bis 4, **dadurch gekennzeichnet, dass** die Deckelplatte (6) als zweite Leiterplatte (22) mit elektronischen Bauelementen (23) ausgebildet ist und die erste und zweite Leiterplatte (2, 22) mittels eines flexiblen Kabels (19) miteinander verbunden sind.

6. Elektronikmodul (1) nach einem der vorherigen Ansprüche 1 bis 5, **dadurch gekennzeichnet, dass** die Vergussmasse (7) die Deckelplatte (6) am Außenumfang übergreifend ausgebildet ist, insbesondere die Vergussmasse (7) die gesamte Deckelplatte (6) bedeckt, wobei insbesondere die zweite Leiterplatte (22) beidseitig mit elektronischen Bauelementen (23, 31) bestückt ist oder weiter bevorzugt die Vergussmasse (7) in einem äußeren Kanal zwischen erster Leiterplatte (2), Deckelplatte (6) und Abstandshaltern (4) eine Gehäuse (26) bildend ausgebildet ist.

7. Elektronikmodul (1) nach einem der vorherigen Ansprüche 1 bis 6, **dadurch gekennzeichnet, dass** ein geschlossener, insbesondere in einem Rechteckprofil geformter, Abstandhaltering (10) die Abstandshalter (4) umfasst und die Vergussmasse (7) jeweils auf gegenüberliegenden Oberflächen des Abstandhalterings (10) zwischen Leiterplatte (2) und Deckelplatte (6) den stirnseitigen, abdichtenden Verschluss ausbildet.

8. Elektronikmodul (1) nach einem der vorherigen Ansprüche 1 bis 7, **dadurch gekennzeichnet, dass** die Trägerplatte (14) mindestens eine Aussparung zur Aufnahme eines Kühlkörpers oder eines Bauteilabschnitts einer Maschinenvorrichtung aufweist, die insbesondere von dem Elektronikmodul gesteuert wird.

9. Elektronikmodul (1) nach einem der Ansprüche 1 bis 8, **dadurch gekennzeichnet, dass** die erste Leiterplatte (2) mit separaten Steckverbindern (13) und Sensoren (12) außerhalb des Gehäuses (26) ausgebildet ist, wobei weiter bevorzugt die Abstandshalter (4) sowohl auf der ersten Leiterplatte (2) als auch der Deckelplatte (6) an komplementären Eckbereichen angeordnet sind.

10. Verfahren zum Herstellen eines Elektronikmoduls (1) nach einem der vorhergehenden Ansprüche mit einem fluiddichten Gehäuse (26) aufweisend:
Bereitstellen einer Leiterplatte (2) mit elektronischen Bauelementen (3),
Bereitstellen von Abstandshaltern (4) zumindest in Eckbereichen auf der Leiterplatte (2),
Bereitstellen einer Deckelplatte (6) auf den Abstandshaltern (4) zur Beabstandung der Deckelplatte (6) zur Leiterplatte, Auftragen und Aushärten einer Vergussmasse (7) an den Außenkanten der Deckelplatte (6) und auf der Leiterplatte (2) zum stirnseitigen Abdichten und stoffschlüssigem Verbinden zwischen Deckplatte (6), Leiterplatte (2) und Abstandshaltern (4) zu einem geschlossenen Gehäuse (26), **dadurch gekennzeichnet, dass** der thermische Längenausdehnungskoeffizient (CTE) von der Vergussmasse (7) in soweit mit den thermischen Längenausdehnungskoeffizienten (CTE) von der Leiterplatte und der Deckelplatte (6) übereinstimmt, dass die Abweichung des thermischen Längenausdehnungskoeffizienten (CTE) zwischen dem CTE der Vergussmasse (7), dem CTE der Leiterplatte und dem CTE der Deckelplatte (6) max. 10 ppm/K beträgt,
wobei die Vergussmasse (7) auf einer Trägerplatte (14) angeordnet wird und insbesondere die erste Leiterplatte (2) direkt auf der Trägerplatte (14) aufliegend angeordnet wird, wobei weiter bevorzugt ein Kabel (19) an der äußeren Oberseite der Deckelplatte (6) zu einem elektrischen Anbauteil einer dritten Leiterplatte (18) auf der Trägerplatte (14) liegend angeordnet wird, wobei besonders bevorzugt die erste Leiterplatte (2) zur Trägerplatte (14), insbesondere mittels der Vergussmasse (7) als Trägerbauteil, beabstandet mit einem Zwischenraum ausgebildet wird und insbesondere der Zwischenraum mit einem Kühlkörper und/oder einer Wärmeleitfolie (25) ausgefüllt wird.

## Claims

1. Electronic module (1), comprising
a first circuit board (2) with electronic components (3),
spacers (4), which are arranged resting at least in corner regions of the first circuit board (2),
a cover plate (6), wherein the cover plate (6) is arranged on the spacers (4),
a potting compound (7), which as an end-face closure seals a gap produced by the spacers (4) between the circuit board (2) and the cover plate (6) with respect to a housing (26) for the electronic components (3) arranged therein,
wherein the potting compound (7) secures the cover plate (6) on the circuit board (2) in a material-bonding manner, **characterized in that** the coefficient of linear thermal expansion (CTE) of the potting compound (7) coincides with the coefficient of linear thermal expansion (CTE) of the circuit board and the cover plate (6) to the extent that the deviation of the coefficient of linear thermal expansion (CTE) between the CTE of the potting compound (7), the CTE of the circuit board and the CTE of the cover plate (6) is a maximum of 10 ppm/K,
wherein the potting compound (7) is arranged on a carrier plate (14) and in particular the first circuit board (2) is arranged resting directly on the carrier plate (14), wherein more preferably a cable (19) is arranged lying on the outer upper side of the cover plate (6) to an electronic add-on part of a third circuit board (18) on the carrier plate (14), wherein particularly preferably the first circuit board (2) is formed at a distance from the carrier plate (14), in particular by means of the potting compound (7) as a carrier component, with an interspace and, in particular, the interspace is filled with a heat sink and/or a heat conducting film (25) .

2. Electronic module (1) according to Claim 1, **characterized in that** the potting compound (7) has a coefficient of linear thermal expansion (CTE) of between 8 ppm/K and 33 ppm/K, preferably between 13 ppm/K and 28 ppm/K, more preferably between 13 ppm/K and 23 ppm/K, in particular 20 ppm/K.

3. Electronic module (1) according to Claim 2, **characterized in that** the circuit board (2) is formed with a CTE of 18 ppm/K, wherein the cover plate (6) is produced from steel, depending on the alloy of Ni steels, with a CTE of between 11 and 20 ppm/K, or from aluminium, with a CTE of around 23 ppm/K, or from epoxy resin, with a CTE of around 20 ppm/K.

4. Electronic module (1) according to one of the preceding Claims 1 to 3, **characterized in that** the potting compound (7) comprises an epoxy resin from the group of amine-curing epoxies.

5. Electronic module (1) according to one of the preceding Claims 1 to 4, **characterized in that** the cover plate (6) is formed as a second circuit board (22) with electronic components (23) and the first and second circuit boards (2, 22) are connected to one another by means of a flexible cable (19).

6. Electronic module (1) according to one of the preceding Claims 1 to 5, **characterized in that** the potting compound (7) is formed as overlapping the cover plate (6) at the outer circumference, in particular the potting compound (7) covers the entire cover plate (6), wherein in particular the second circuit board (22) is populated on both sides with electronic components (23, 31) or more preferably the potting compound (7) is formed in an outer channel between the first circuit board (2), the cover plate (6) and the spacers (4), forming a housing (26).

7. Electronic module (1) according to one of the preceding Claims 1 to 6, **characterized in that** a closed spacer ring (10), shaped in particular in a rectangular profile, comprises the spacers (4) and the potting compound (7) forms the end-face, sealing closure in each case on opposite surfaces of the spacer ring (10) between the circuit board (2) and the cover plate (6).

8. Electronic module (1) according to one of the preceding Claims 1 to 7, **characterized in that** the carrier plate (14) has at least one clearance for receiving a heat sink or a component portion of a machine device that is controlled in particular by the electronic module.

9. Electronic module (1) according to one of Claims 1 to 8, **characterized in that** the first circuit board (2) is formed with separate plug-in connectors (13) and sensors (12) outside the housing (26), wherein more preferably the spacers (4) are arranged both on the first circuit board (2) and the cover plate (6) at complementary corner regions.

10. Method for producing an electronic module (1) according to one of the preceding claims having a fluid-tight housing (26) comprising:
providing a circuit board (2) having electronic components (3),
providing spacers (4) at least in corner regions on the circuit board (2),
providing a cover plate (6) on the spacers (4) for keeping the cover plate (6) at a distance from the circuit board,
applying and curing a potting compound (7) at the outer edges of the cover plate (6) and on the circuit board (2), for the end-face sealing and material-bonding connection between the cover plate (6), the circuit board (2) and the spacers (4) to form a closed housing (26), **characterized in that** the coefficient of linear thermal expansion (CTE) of the potting compound (7) coincides with the coefficient of linear thermal expansion (CTE) of the circuit board and the cover plate (6) to the extent that the deviation of the coefficient of linear thermal expansion (CTE) between the CTE of the potting compound (7), the CTE of the circuit board and the CTE of the cover plate (6) is a maximum of 10 ppm/K,
wherein the potting compound (7) is arranged on a carrier plate (14) and in particular the first circuit board (2) is arranged resting directly on the carrier plate (14), wherein more preferably a cable (19) is arranged lying on the outer upper side of the cover plate (6) to an electronic add-on part of a third circuit board (18) on the carrier plate (14),
wherein particularly preferably the first circuit board (2) is formed at a distance from the carrier plate (14), in particular by means of the potting compound (7) as a carrier component, with an interspace and, in particular, the interspace is filled with a heat sink and/or a heat conducting film (25) .

## Revendications

1. Module électronique (1), comprenant :
une première carte de circuits imprimés (2) avec des composants électroniques (3),
des entretoises (4) qui sont disposées en appui au moins dans des zones d'angle de la première carte de circuits imprimés (2),
une plaque de recouvrement (6), la plaque de recouvrement (6) étant disposée sur les entretoises (4),
une masse de scellement (7) qui, en tant que fermeture frontale, rend étanche un espacement généré par les entretoises (4) entre la carte de circuits imprimés (2) et la plaque de recouvrement (6) par rapport à un boîtier (26) pour les composants électroniques (3) disposés à l'intérieur,
la masse de scellement (7) fixant par liaison de matière la plaque de recouvrement (6) sur la carte de circuits imprimés (2),
**caractérisé en ce que** le coefficient de dilatation thermique longitudinale (CTE) de la masse de scellement (7) coïncide avec les coefficients de dilatation thermique longitudinale (CTE) de la carte de circuits imprimés et de la plaque de recouvrement (6) à tel point que l'écart du coefficient de dilatation thermique longitudinale (CTE) entre le CTE de la masse de scellement (7), le CTE de la carte de circuits imprimés et le CTE de la plaque de recouvrement (6) est au maximum égal à 10 ppm/K,
la masse de scellement (7) étant disposée sur une plaque de support (14), et en particulier la première carte de circuits imprimés (2) étant disposée directement en appui sur la plaque de support (14), dans lequel de plus grande préférence, un câble (19) est disposé sur la face supérieure extérieure de la plaque de recouvrement (6) à plat sur la plaque de support (14) jusqu'à une pièce rapportée électrique d'une troisième carte de circuits imprimés (18), dans lequel, de manière particulièrement préférée, la première carte de circuits imprimés (2) est réalisée à distance de la plaque de support (14), en particulier au moyen de la masse de scellement (7) comme composant de support, avec un intervalle, et l'intervalle est en particulier rempli d'un dissipateur thermique et/ou d'un film thermoconducteur (25).

2. Module électronique (1) selon la revendication 1, **caractérisé en ce que** la masse de scellement (7) présente un coefficient de dilatation thermique longitudinale (CTE) compris entre 8 ppm/K et 33 ppm/K, de préférence entre 13 ppm/K et 28 ppm/K, de plus grande préférence entre 13 ppm/K et 23 ppm/K, en particulier de 20 ppm/K.

3. Module électronique (1) selon la revendication 2, **caractérisé en ce que** la carte de circuits imprimés (2) est réalisée avec un CTE de 18 ppm/K, la plaque de recouvrement (6) étant fabriquée en acier, selon l'alliage d'aciers Ni avec un CTE compris entre 11 et 20 ppm/K, ou en aluminium avec un CTE de 23 ppm/K, ou en résine époxy d'un CTE d'environ 20 ppm/K.

4. Module électronique (1) selon l'une quelconque des revendications précédentes 1 à 3, **caractérisé en ce que** la masse de scellement (7) comprend une résine époxy issue du groupe des époxydes à durcissement aminique.

5. Module électronique (1) selon l'une quelconque des revendications précédentes 1 à 4, **caractérisé en ce que** la plaque de recouvrement (6) est réalisée comme une deuxième carte de circuits imprimés (22) avec des composants électroniques (23), et les première et deuxième cartes de circuits imprimés (2, 22) sont reliées l'une à l'autre au moyen d'un câble flexible (19) .

6. Module électronique (1) selon l'une quelconque des revendications précédentes 1 à 5, **caractérisé en ce que** la masse de scellement (7) est réalisée en recouvrant la plaque de recouvrement (6) sur la périphérie extérieure, en particulier **en ce que** la masse de scellement (7) recouvre toute la plaque de recouvrement (6), dans lequel en particulier, la deuxième carte de circuits imprimés (22) est équipée de composants électroniques (23, 31) des deux côtés, ou de plus grande préférence, la masse de scellement (7) est réalisée dans un canal extérieur entre la première carte de circuits imprimés (2), la plaque de recouvrement (6) et les entretoises (4) en formant un boîtier (26).

7. Module électronique (1) selon l'une quelconque des revendications précédentes 1 à 6, **caractérisé en ce qu'**une bague d'espacement (10) fermée, en particulier formée avec un profil rectangulaire, saisit les entretoises (4), et la masse de scellement (7) réalise respectivement sur des surfaces opposées de la bague d'espacement (10) la fermeture frontale d'étanchéité entre la carte de circuits imprimés (2) et la plaque de recouvrement (6).

8. Module électronique (1) selon l'une quelconque des revendications précédentes 1 à 7, **caractérisé en ce que** la plaque de support (14) présente au moins un évidement pour recevoir un dissipateur thermique ou une partie de composant d'un dispositif de machine qui est commandé en particulier par le module électronique.

9. Module électronique (1) selon l'une quelconque des revendications 1 à 8, **caractérisé en ce que** la première carte de circuits imprimés (2) est réalisée avec des connecteurs enfichables (13) et des capteurs (12) séparés à l'extérieur du boîtier (26), dans lequel de plus grande préférence, les entretoises (4) sont disposées aussi bien sur la première carte de circuits imprimés (2) et sur la plaque de recouvrement (6) dans des zones d'angle complémentaires.

10. Procédé de fabrication d'un module électronique (1) selon l'une quelconque des revendications précédentes, comprenant un boîtier étanche au fluide (26), comprenant les étapes consistant à :
prévoir une carte de circuits imprimés (2) avec des composants électroniques (3),
prévoir des entretoises (4) au moins dans des zones d'angle sur la carte de circuits imprimés (2),
prévoir une plaque de recouvrement (6) sur les entretoises (4) pour espacer la plaque de recouvrement (6) par rapport à la carte de circuits imprimés,
appliquer et laisser durcir une masse de scellement (7) sur les bords extérieurs de la plaque de recouvrement (6) et sur la carte de circuits imprimés (2) pour une étanchéité frontale et une connexion par liaison de matière entre la plaque de recouvrement (6), la carte de circuits imprimés (2) et les entretoises (4) en un boîtier fermé (26),
**caractérisé en ce que** le coefficient de dilatation thermique longitudinale (CTE) de la masse de scellement (7) coïncide avec les coefficients de dilatation thermique longitudinale (CTE) de la carte de circuits imprimés et de la plaque de recouvrement (6) à tel point que l'écart du coefficient de dilatation thermique longitudinale (CTE) entre le CTE de la masse de scellement (7), le CTE de la carte de circuits imprimés et le CTE de la plaque de recouvrement (6) est au maximum égal à 10 ppm/K,
la masse de scellement (7) étant disposée sur une plaque de support (14), et en particulier la première carte de circuits imprimés (2) étant disposée directement en appui sur la plaque de support (14), dans lequel de plus grande préférence, un câble (19) est disposé sur la face supérieure extérieure de la plaque de recouvrement (6) à plat sur la plaque de support (14) jusqu'à une pièce rapportée électrique d'une troisième carte de circuits imprimés (18), dans lequel, de manière particulièrement préférée, la première carte de circuits imprimés (2) est réalisée à distance de la plaque de support (14), en particulier au moyen de la masse de scellement (7) comme composant de support, avec un intervalle, et l'intervalle est en particulier rempli d'un dissipateur thermique et/ou d'un film thermoconducteur (25).
